# EUROPEAN PATENT APPLICATION

(11) **EP 4 535 407 A1**
(43) Date of publication of application: **09.04.2025**
(21) Application number: 23814989.2
(22) Date of filing: 19.05.2023
(51) Int. Cl.: H01L 21/67

(54) **SEMICONDUCTOR HEAT TREATMENT DEVICE AND CONTROL METHOD THEREFOR**

(30) Priority: 30.05.2022 CN 202210600893
(71) Applicant: Beijing NAURA Microelectronics Equipment Co., Ltd., Beijing 100176 (CN)
(72) Inventor: ZHOU, Liying, Beijing 100176 (CN); YANG, Shuai, Beijing 100176 (CN)
(74) Representative: Cohausz & Florack
(86) International application number: PCT/CN2023/095228
(87) International publication number: WO 2023/231805

(57) **Abstract**

The present disclosure provides a semiconductor heat treatment device and a control method therefor. The semiconductor heat treatment device includes a process chamber, a gas intake pipeline, a gas conveying pipeline, and an exhaust pipeline, one end of the gas intake pipeline is communicated with a gas source, the other end of the gas intake pipeline is communicated with the gas conveying pipeline located in the process chamber, the gas conveying pipeline is parallel to a central axis of the process chamber, the gas conveying pipeline is provided with a plurality of gas holes, and each of the plurality of gas holes is configured to convey a process gas into the process chamber; and the exhaust pipeline is communicated with the process chamber, a gas storage assembly is disposed on the gas intake pipeline, and is configured to supply the process gas to the process chamber through the gas intake pipeline and the gas conveying pipeline in sequence in a case where a gas storage amount reaches a first preset value. The above technical solution can solve the problem that a concentration of the process gas at a position farther away from the gas intake pipeline in the process chamber is smaller during a process.

## Description

### TECHNICAL FIELD

The present disclosure relates to the field of semiconductor manufacturing technology, and in particular, to a semiconductor heat treatment device and a control method therefor.

### BACKGROUND

In a manufacturing process of a semiconductor, a structure such as an insulating layer or a dielectric layer may be formed from a process gas on a surface of the semiconductor such as a wafer. At present, a plurality of wafers are generally arranged along a specific direction such as a height direction and are accommodated in a process chamber, and the process gas supplied by a gas source is fed into the process chamber through a gas intake pipeline to be deposited on the surfaces of the plurality of wafers. However, a pressure of the process gas is relatively low in a feeding process of the process gas due to an influence of process characteristics, and since the process chamber is provided with an exhaust pipeline, a concentration of the process gas at a position farther away from the gas intake pipeline in the process chamber is smaller after the process gas is fed into the process chamber, such that a process result of a wafer at such position fails to meet requirements.

### SUMMARY

The present disclosure provides a semiconductor heat treatment device and a control method therefor, so as to solve the problem that the concentration of the process gas at the position farther away from the gas intake pipeline in the process chamber is smaller during the process, such that the process result of the wafer at such position fails to meet the requirements.

In order to solve the above problem, the present disclosure adopts the following technical solutions.

In a first aspect, the present disclosure provides a semiconductor heat treatment device, including a process chamber, a gas intake pipeline, a gas conveying pipeline, and an exhaust pipeline, one end of the gas intake pipeline is communicated with a gas source, the other end of the gas intake pipeline is communicated with the gas conveying pipeline located in the process chamber, the gas conveying pipeline is parallel to a central axis of the process chamber, the gas conveying pipeline is provided with a plurality of gas holes, and each of the plurality of gas holes is configured to convey a process gas into the process chamber; and the exhaust pipeline is communicated with the process chamber, and a gas storage assembly is disposed on the gas intake pipeline, and is configured to supply the process gas to the process chamber through the gas intake pipeline and the gas conveying pipeline in sequence in a case where a gas storage amount reaches a first preset value.

In a second aspect, the present disclosure provides a control method for a semiconductor heat treatment device, including:
introducing a gas into a gas storage assembly through a gas intake pipeline; and
supplying a process gas to a process chamber in a case where a gas storage amount of the gas storage assembly reaches a first preset value.

The technical solutions adopted by the present disclosure can produce the following beneficial effects.

In the semiconductor heat treatment device provided in embodiments of the present disclosure, one end of the gas intake pipeline is communicated with the gas source, the other end of the gas intake pipeline is communicated with the gas conveying pipeline located in the process chamber, the gas conveying pipeline is parallel to the central axis of the process chamber, the gas conveying pipeline is provided with the plurality of gas holes, and each of the plurality of gas holes is configured to convey the process gas into the process chamber. The process chamber is further communicated with the exhaust pipeline to ensure an unobstructed gas path, and the exhaust pipeline can be further configured to stabilize an operating pressure in the process chamber.

In the semiconductor heat treatment device, the gas storage assembly is disposed on the gas intake pipeline. In a case where the gas storage amount of the process gas in the gas storage member reaches the first preset value, the gas storage assembly supplies the process gas to the process chamber through the gas intake pipeline and the gas conveying pipeline in sequence, so that the process gas in the gas storage member can be quickly diffused into the gas conveying pipeline through the gas intake pipeline under the action of a pressure of the process gas itself. Since the process gas in the gas storage member has a certain pressure, the process gas after being output from the gas storage member can be reliably moved to a gas hole in the gas conveying pipeline which is far away from the gas storage member, so that it can be ensured that the process gas can be uniformly output through the plurality of gas holes of the gas conveying pipeline, thereby ensuring that a process result of each wafer meets process requirements.

### BRIEF DESCRIPTION OF DRAWINGS

The drawings described here are intended to provide a further understanding of the present disclosure and constitutes a part of the present application. The exemplary embodiments of the present disclosure and the description thereof are intended to explain the present disclosure, but do not constitute improper limitation to the present disclosure. In the drawings:
FIG. 1 is a schematic structural diagram of a semiconductor heat treatment device according to an embodiment of the present disclosure;
FIG. 2 is a schematic structural diagram of a gas conveying pipeline in a semiconductor heat treatment device according to an embodiment of the present disclosure;
FIG. 3 is another schematic structural diagram of a gas conveying pipeline in a semiconductor heat treatment device according to an embodiment of the present disclosure;
FIG. 4 is a schematic structural diagram of a gas storage member in a semiconductor heat treatment device according to an embodiment of the present disclosure;
FIG. 5 is another schematic structural diagram of a gas storage member in a semiconductor heat treatment device according to an embodiment of the present disclosure; and
FIG. 6 is a flowchart illustrating a control method for a semiconductor heat treatment device according to an embodiment of the present disclosure.

### Description of reference numerals:

110-gas intake section, 120-communication section, 130-exhaust pipeline, 140-gas conveying pipeline, 141-gas hole,
210-process chamber, 220-rotating mechanism,
310-gas storage member, 311-first buffer section, 312-straight section, 313-second buffer section, 320-Vacuum Coupling Radius Seal joint, 330-joint connector,
410-first valve, 420-second valve, 430-third valve, 440-first pressure regulating valve, 450-second pressure regulating valve,
510-first pressure detection element, 520-second pressure detection element, 530-mass flow controller,
600-waste gas treatment apparatus,
900-wafer.

### DETAIL DESCRIPTION OF EMBODIMENTS

In order to make the objectives, technical solutions and advantages of the present disclosure clearer, the technical solutions of the present disclosure are clearly and thoroughly described below in conjunction with the specific embodiments of the present disclosure and the corresponding drawings. Apparently, the embodiments described herein are merely some embodiments of the present disclosure, and do not cover all embodiments. All other embodiments derived by those of ordinary skill in the art from the embodiments described herein without inventive work fall within the scope of the present disclosure.

The technical solutions provided in each embodiment of the present disclosure are described in detail below with reference to the drawings.

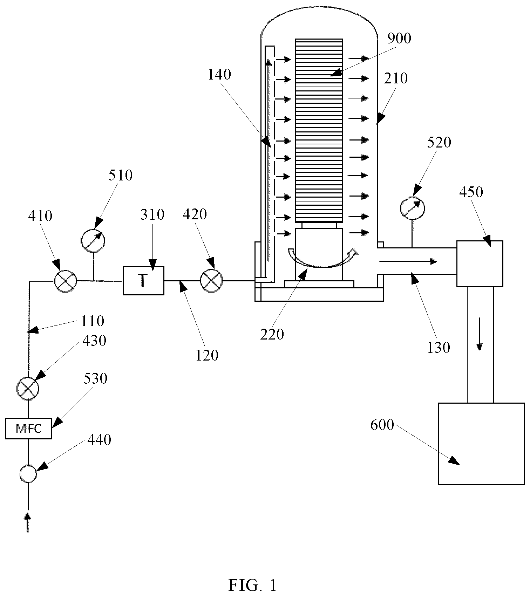

As shown in FIG. 1 to FIG. 5, an embodiment of the present disclosure provides a semiconductor heat treatment device, which can enable a wafer 900 and a process gas to interact so as to deposit the process gas on a surface of the wafer 900. The semiconductor heat treatment device specifically includes a gas intake pipeline, an exhaust pipeline 130, a gas conveying pipeline 140, a process chamber 210, and a gas storage assembly. The gas storage assembly is disposed on the gas intake pipeline. For convenience of description below, the gas intake pipeline is divided into a gas intake section 110 and a communication section 120. The gas storage assembly has a gas storage stage and a gas release stage. In order to ensure that the gas storage assembly is capable of being switched between the gas storage stage and the gas release stage, the gas storage assembly may include a gas storage member 310, a first valve 410, and a second valve 420.

The process chamber 210 may provide a process environment and an accommodating space for the processing of the wafer 900, and allow the process gas to be supplied into the process chamber 210 to react with the wafer 900. During the processing of the wafer 900, a plurality of semiconductors such as a plurality of wafers 900 may be accommodated and regularly arranged in the process chamber 210. Specifically, the plurality of wafers 900 may be distributed along a height direction of the process chamber 210. Certainly, in order to ensure that the process gas may be deposited on a surface of each wafer 900, a gap needs to be provided between any two adjacent wafers 900 among the plurality of wafers 900. In addition, a bearing mechanism may be disposed in the process chamber 210 for bearing the plurality of wafers 900, and may be specifically a wafer boat.

The process gas may be supplied by a gas source, which may be a gas storage device. In order to ensure safety of the process gas used in the semiconductor processing, the gas source may be a gas supply pipeline, so as to avoid potential safety hazards caused when the process gas is kept in a high pressure state for a long time.

In a process of conveying the process gas, one end of the gas intake section 110 of the gas intake pipeline may be communicated with the gas source, and the other end of the gas intake section 110 may be communicated with the gas storage member 310, so as to enable the process gas to be conveyed into the gas storage member 310 through the gas intake section 110. Specifically, the gas intake section 110 may be made of a metal material such as stainless steel, which may also prevent the process gas from reacting with the gas intake section 110 to avoid an adverse effect on the process. Connecting components such as joints and gaskets may be adopted for communication between the gas intake section 110 and each of the gas source and the gas storage member 310, and may ensure reliable sealing connection between the gas intake section 110 and the gas source and between the gas intake section 110 and the gas storage member 310. In addition, all parameters of the gas intake section 110 such as a length and a flow may be determined according to actual needs, and are not limited herein.

Meanwhile, the first valve 410 is disposed on the gas intake section 110 of the gas intake pipeline, that is, the first valve 410 is disposed on a portion of the gas intake pipeline which is located upstream of the gas storage member 310, so as to control a connection state and a disconnection state of the gas intake section 110 and the gas storage member 310. In a case where the first valve 410 is closed, the gas intake section 110 is disconnected from the gas storage member 310, and the process gas output by the gas source cannot be conveyed into the gas storage member 310 through the gas intake section 110; correspondingly, in a case where the first valve 410 is open, the gas intake section 110 and the gas storage member 310 are communicated with each other, and the process gas output by the gas source may be conveyed into the gas storage member 310 through the gas intake section 110. Specifically, the first valve 410 may be a solenoid valve or a pneumatic valve.

As stated above, the process chamber 210 may provide the process environment for the wafer 900. On such basis, in order to ensure that the process gas can be conveyed into the process chamber 210 and can be uniformly conveyed to a region where the plurality of wafers 900 are located, optionally, the gas conveying pipeline 140 is disposed inside the process chamber 210, so as to convey the process gas to different regions of the process chamber 210. Meanwhile, in order to ensure as much as possible that the process gas can be conveyed to any position in the process chamber 210 through the gas conveying pipeline 140, the gas conveying pipeline 140 may be disposed parallel to a central axis of the process chamber 210. The central axis of the process chamber is along the height direction of the process chamber 210, that is, along an arrangement direction of the wafers 900 in the process chamber 210.

More specifically, the gas conveying pipeline 140 may be provided with a plurality of gas holes 141 each configured to convey the process gas into the process chamber 210, and the plurality of gas holes 141 are distributed along the arrangement direction of the plurality of wafers 900 accommodated in the process chamber 210, so that a gas conveying region formed by the plurality of gas holes 141 may correspond to the region where the plurality of wafers 900 are located, and the gas conveying pipeline 140 may cover the region where the plurality of wafers 900 are located as much as possible, so as to enable the process gas to act on each wafer 900.

As shown in FIG. 1, the gas storage member 310 is communicated with one end of the gas conveying pipeline 140 through the communication section 120 of the gas intake pipeline, so as to ensure that the process gas in the gas storage member 310 can be conveyed into the process chamber 210 through the communication section 120 and the gas conveying pipeline 140. The communication section 120 may be also made of a metal material, and both the gas storage member 310 and the gas conveying pipeline 140 are hermetically connected to the communication section 120.

Certainly, in order to enable the process gas in the gas storage member 310 to be conveyed into the process chamber 210 in a controllable manner, as shown in FIG. 1, the second valve 420 is disposed on the communication section 120, that is, the second valve 420 is disposed on a portion of the gas intake pipeline which is located downstream of the gas storage member 310, so that connection and disconnection between the gas storage member 310 and the process chamber 210 may be controlled by opening and closing the second valve 420. Specifically, in a case where the second valve 420 is open, the process gas in the gas storage member 310 may be conveyed into the process chamber 210 through the communication section 120; and in a case where the second valve 420 is closed, the process gas in the gas storage member 310 cannot be conveyed into the process chamber 210. The second valve 420 may be a solenoid valve or a pneumatic valve.

In addition, in order to discharge a waste gas generated during the process out of the process chamber 210 during the process and after the process, in the semiconductor heat treatment device provided in the embodiments of the present disclosure, the process chamber 210 is further communicated with one end of the exhaust pipeline 130, and the other end of the exhaust pipeline 130 is configured to be communicated with a waste gas processing apparatus 600. In this way, if a pressure of the process chamber 210 exceeds a preset pressure range during the process, the gas in the process chamber 210 may be extracted with the waste gas processing apparatus 600, so as to reduce the pressure in the process chamber 210 to the preset pressure range and improve a process effect. Certainly, the waste gas in the process chamber 210 may be also extracted with the waste gas treatment apparatus 600 after the process is completed.

In order to minimize an adverse effect of the waste gas in the exhaust pipeline 130 on a process carried out in the process chamber 210, optionally, the exhaust pipeline 130 may be provided with a second pressure regulating valve 450, and connection and disconnection of the waste gas treatment apparatus 600 and the process chamber 210 may be enabled with the second pressure regulating valve 450. In addition, in order to accurately perceive a specific pressure situation in the process chamber 210, the exhaust pipeline 130 may be further provided with a second pressure detection element 520 located between the process chamber 210 and the second pressure regulating valve 450, so that whether the pressure in the process chamber 210 is within the preset pressure range may be determined with the second pressure detection element 520, and the pressure in the process chamber 210 may be regulated with the second pressure regulating valve 450 in a case where the pressure in the process chamber 210 exceeds the preset pressure range, thereby ensuring that an operation pressure in the process chamber 210 is always within the preset pressure range and improving the process effect.

Based on the above semiconductor heat treatment device, when there is a need to carry out a process by the semiconductor heat treatment device, the plurality of wafers 900 may be first placed in the process chamber 210, and the process environment in the process chamber 210 may be processed through the exhaust pipeline 130 and the waste gas treatment apparatus 600 to meet process requirements. Then, the first valve 410 may be opened and the second valve 420 may be closed, so that the process gas supplied by the gas source may be conveyed into the gas storage member 310 through the gas intake section 110 for storage. As the process gas is continuously conveyed into the gas storage member 310, a pressure of the process gas in the gas storage member 310 is also increased. The amount of the process gas required for performing the corresponding process on the plurality of wafers 900 may be obtained according to parameters such as the number and sizes of the wafers 900 in the process chamber 210 together with a specific type of the corresponding process. Then, in a case where a gas storage amount of the process gas in the gas storage member 310 reaches a first preset value, the first valve 410 is closed, and the second valve 420 is opened, so that the process gas stored in the gas storage member 310 may be quickly conveyed into the gas conveying pipeline 140 through the communication section 120 under the action of the pressure of the process gas itself, and may be conveyed into the process chamber 210 through the plurality of gas holes 141 in the gas conveying pipeline 140. Certainly, it needs to be ensured that the process gas conveyed into the gas conveying pipeline 140 from the gas storage member 310 through the communication section 120 has a high pressure, so as to ensure an equal gas pressure of each gas hole 141 in the gas conveying pipeline, thereby making the process gas conveyed into the process chamber 210 through the gas conveying pipeline 140 be uniform in amount at all positions in the process chamber 210. For achieving such objective, the gas storage amount of the process gas remaining in the gas storage member 310 may be controlled, and the gas storage member 310 is controlled with the second valve 420 to stop supplying the gas to the process chamber in a case where a gas pressure in the gas storage member 310 is slightly greater than or equal to a gas pressure in the process chamber 210.

Specifically, a device such as a flowmeter may be adopted to measure the amount of the process gas conveyed into the gas storage member 310 through the gas intake section 110 within a preset time period; or, parameters such as the pressure of the process gas in the gas storage member 310 when the amount of the process gas stored in the gas storage member 310 meets the process requirements may be obtained according to parameters such as a kind of the process gas and a volume of the gas storage member 310, and then the pressure of the process gas in the gas storage member 310 may be detected with the pressure detection element, so as to indirectly obtain the amount of the process gas stored in the gas storage member 310.

In the semiconductor heat treatment device provided in the embodiments of the present disclosure, one end of the gas intake pipeline is communicated with the gas source, and the other end of the gas intake pipeline is communicated with the gas conveying pipeline located in the process chamber. Specifically, the gas source is communicated with the gas storage member 310 through the gas intake section 110 of the gas intake pipeline, the gas storage member 310 is communicated with the gas conveying pipeline 140 located in the process chamber 210 through the communication section 120 of the gas intake pipeline, and the gas conveying pipeline 140 is parallel to the central axis of the process chamber 210, and is provided with the plurality of gas holes 141 each configured to convey the process gas to the process chamber 210. The process chamber 210 is further communicated with the exhaust pipeline 130 to ensure an unobstructed gas path, and the exhaust pipeline 130 may be further configured to stabilize the operating pressure in the process chamber 210.

In the above semiconductor heat treatment device, in a case where the gas storage amount of the process gas in the gas storage member 310 reaches the first preset value, the gas storage member 310 supplies the process gas to the process chamber 210 through the gas intake pipeline and the gas conveying pipeline 140 in sequence, and the process gas in the gas storage member 310 can be quickly diffused into the gas conveying pipeline 140 through the communication section 120 under the action of the pressure of the process gas itself. Since the process gas in the gas storage member 310 has a certain pressure, the process gas after being output from the gas storage member 310 can be reliably moved to a gas hole 141 in the gas conveying pipeline 140 which is far away from the gas storage member 310, so that it can be ensured that the process gas can be uniformly output through the plurality of gas holes 141 of the gas conveying pipeline 140, thereby ensuring that a process result of each wafer 900 meets the process requirements.

As stated above, the amount of the process gas stored in the gas storage member 310 may be obtained by measuring the flow or the pressure. In a specific implementation, the semiconductor heat treatment device further includes a first pressure detection element 510, which is disposed on the gas intake pipeline and located between the first valve 410 and the gas storage member 310, that is, disposed on the gas intake section 110 of the gas intake pipeline. The first pressure detection element 510 is configured to detect the gas in the gas storage member 310. Specifically, the first pressure detection element 510 may be a pressure gauge or a pressure sensor. Under the condition that the parameters such as the volume of the gas storage member 310 and the kind of the process gas are known, the amount of the process gas stored in the gas storage member 310 may be indirectly obtained according to a measurement value of the first pressure detection element 510.

In another embodiment of the present disclosure, the semiconductor heat treatment device further includes a mass flow controller 530, which is installed on the gas intake section 110. Under the action of the mass flow controller (MFC) 530, the amount of the process gas conveyed into the gas storage member 310 through the gas intake section 110 within the preset time period may be obtained more accurately, which may improve accuracy of a measurement value of the amount of the process gas in the gas storage member 310.

In order to further improve the accuracy of the measurement value of the amount of the process gas in the gas storage member 310, optionally, the first pressure detection element 510 together with the mass flow controller 530 may be disposed in the semiconductor heat treatment device, so as to obtain the amount of the process gas stored in the gas storage member 310 from multiple dimensions, thereby improving the accuracy of the measurement value to the greatest extent.

In order to further facilitate controlling the conveying process of the process gas, optionally, the semiconductor heat treatment device further includes a third valve 430, which is installed between the first valve 410 and the mass flow controller 530. The third valve 430 may be closed when there is no need to convey the process gas, so as to improve safety of the conveying of the process gas.

In addition, the semiconductor heat treatment device may further include a first pressure regulating valve 440, which is installed on the gas intake section 110. The first pressure regulating valve 440 is located between the mass flow controller 530 and the gas source, so that a conveying pressure of the process gas in the gas intake section 110 may be regulated with the first pressure regulating valve 440 when the process gas needs to be conveyed to the semiconductor heat treatment device during the process, so as to improve the stability of the conveying of the process gas.

In order to further improve uniformity in the amount of the process gas conveyed to each of the plurality of wafers 900 in the process chamber 210, structures and/or arrangement of the gas holes 141 in the gas conveying pipeline 140 may be designed to realize a substantially equal amount of the process gas conveyed to each wafer 900.

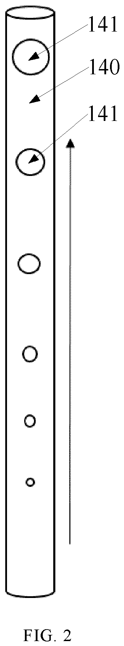

Optionally, as shown in FIG. 2, the plurality of gas holes 141 are distributed along the central axis of the process chamber 210, and gas-conveying section areas of the plurality of gas holes 141 gradually increase along a gas conveying direction (as shown by the arrow in FIG. 2) of the gas conveying pipeline 140, that is, each gas hole has a different gas-conveying section area, and the farther the gas hole 141 is away from the communication section 120, the larger the gas-conveying section area of the gas hole 141 is. The gas-conveying section area of each gas hole 141 is an area of a cross section of the gas hole 141 perpendicular to an axial direction of the gas hole 141, and may represent a gas conveying capability of the gas hole 141; and the larger the gas-conveying section area is, the better the gas conveying capability of the gas hole 141 is. By adopting such technical solution, even if there is a difference in the pressures of the process gas at the different gas holes 141, since the gas hole 141 farther way from the gas storage member 310 has the larger gas-conveying section area, an adverse effect of a lower pressure of the process gas at the gas hole 141 farther way from the gas storage member 310 on a gas output amount of the gas hole 141 farther way from the gas storage member 310 may be compensated, so as to ensure as much as possible that the plurality of gas holes 141 are the same in gas output amount. In addition, by adopting the above technical solution, an equal distance may be provided between any two adjacent gas holes 141.

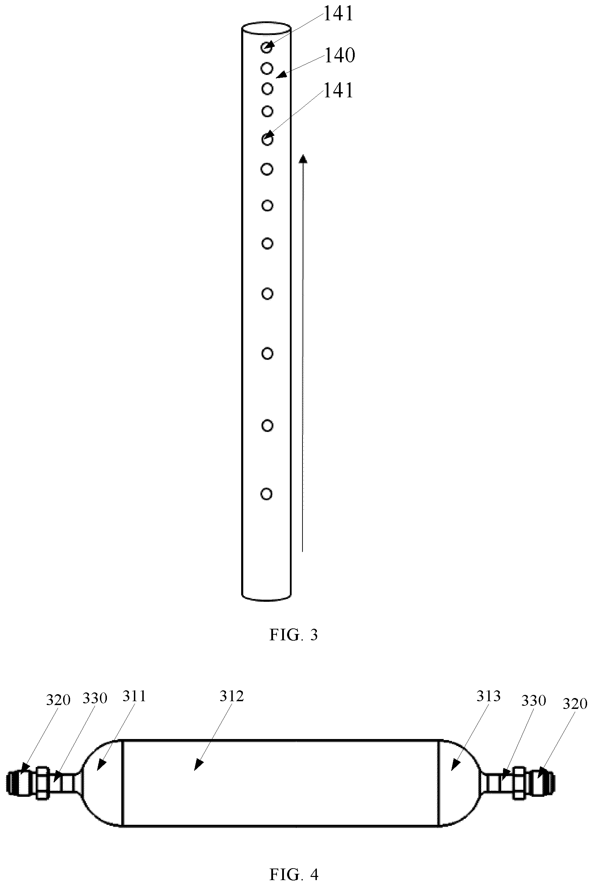

As shown in FIG. 3, in another embodiment of the present disclosure, the plurality of gas holes 141 are distributed along the central axis of the process chamber 210, and a distance between any adjacent two gas holes 141 among the plurality of gas holes 141 gradually decreases along a gas conveying direction (as shown by the arrow in FIG. 3) of the gas conveying pipeline 140. That is, in a process of arranging the gas holes 141 in the gas conveying pipeline 140, the gas holes 141 at positions farther away from the communication section 120 are denser. In this way, even if the gas pressures at the gas holes 141 at the positions farther away from the communication section 120 are lower due to the larger distances between the gas holes 141 at the positions farther away from the communication section 120 and the gas storage member 310, an adverse effect of the lower gas pressures may be compensated by increasing the density of the gas holes 141, thereby ensuring the substantially equal amount of the process gas conveyed to each of the plurality of wafers 900. In addition, in the semiconductor heat treatment device provided in the embodiments of the present disclosure, each gas hole 141 may have the same radius, so as to reduce difficulty in processing the gas holes 141.

In another embodiment of the present disclosure, the plurality of gas holes 141 are distributed along the central axis of the process chamber 210, gas-conveying section areas of the plurality of gas holes 141 gradually increase along a gas conveying direction of the gas conveying pipeline 140, and meanwhile, a distance between any two adjacent gas holes 141 among the plurality of gas holes 141 gradually decreases, so as to improve the uniformity in gas conveying amount of the plurality of gas holes 141 to the greatest extent. Certainly, specific parameters of the gas-conveying section areas of the gas holes 141 and the distance between any two adjacent gas holes 141 may be adaptively adjusted in practical applications, so as to ensure a substantially equal gas conveying amount of each of the plurality of gas holes 141.

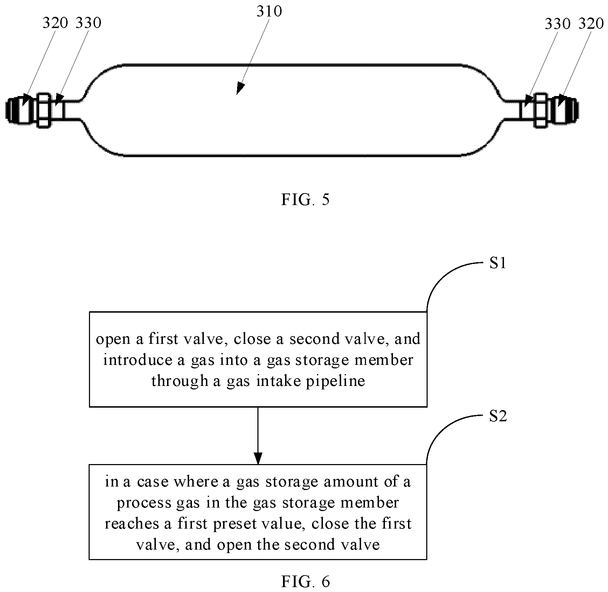

As stated above, the gas storage member 310 may store the process gas to pressurize the process gas therein, so as to improve a diffusion capability and a diffusion speed of the process gas, thereby improving uniformity of the process gas at the different regions in the process chamber 210. On such basis, in order to improve storage and release performance of the process gas of the gas storage member 310, optionally, as shown in FIG. 4 and FIG. 5, the gas storage member 310 includes a first buffer section 311, a straight section 312, and a second buffer section 313, which are sequentially connected in series along a gas intake direction (i.e., the directions from left to right shown in FIG. 4 and FIG. 5), and the first buffer section 311, the straight section 312, and the second buffer section 313 form the gas storage member 310 together. In a process of assembling the gas storage member 310, one end of the gas intake section 110 is configured to be communicated with the gas source, the other end of the gas intake section 110 is communicated with one end of the first buffer section 311 away from the straight section 312, one end of the second buffer section 313 away from the straight section 312 is communicated with one end of the communication section 120, and the other end of the communication section 120 is communicated with the gas conveying pipeline 140.

Specifically, each of the first buffer section 311, the second buffer section 313, and the straight section 312 may be made of a material with a high structural strength such as metal, so as to improve gas storage performance of the gas storage member 310. Moreover, the first buffer section 311 and the second buffer section 313 may be fixedly connected to the straight section 312 by welding. In order to improve connection reliability of the first buffer section 311, the second buffer section 313, and the straight section 312, optionally, the first buffer section 311, the straight section 312, and the second buffer section 313 may be integrally formed.

In addition, along the gas intake direction of the gas storage member 310, an area of a section of the first buffer section 311 which is perpendicular to the gas intake direction (i.e., the directions from left to right shown in FIG. 4 and FIG. 5) gradually increases, and an area of a section of the second buffer section 313 which is perpendicular to the gas intake direction (i.e., the directions from left to right shown in FIG. 4 and FIG. 5) gradually decreases, so that the first buffer section 311 and the second buffer section 313 have smooth structures, and the gas may be gradually diffused after entering the gas storage member 310 through the first buffer section 311, which reduces difficulty in conveying the gas, and the gas may be gradually compressed and organized at the second buffer section 313 while being conveyed into the gas conveying pipeline 140 from the second buffer section 313 through the communication section 120, which improves the diffusion speed and a diffusion effect of the process gas.

In addition, under the condition that both the first buffer section 311 and the second buffer section 313 have the smooth structures, the process gas may be prevented from being blocked when flowing in the gas storage member 310 as much as possible, which improves a flow capability of the process gas. Correspondingly, in order to further prevent the process gas from being blocked when flowing from the first buffer section 311 to the second buffer section 313, a shape of a projection of the straight section 312 along the gas intake direction may be made to be the same as a shape of a section of the straight section 312 which is perpendicular to the gas intake direction, that is, the straight section 312 is a straight structural member as a whole, which may prevent the process gas from being blocked by the straight section 312 when flowing in the gas storage member 310, thereby ensuring flow smoothness of the process gas.

More specifically, the straight section 312 may be a cylindrical structural member, and correspondingly, an end surface of the first buffer section 311 which is connected to the straight section 312 and an end surface of the second buffer section 313 which is connected to the straight section 312 are both circular structures, which may further improve flow performance of the process gas in the gas storage member 310, and prevent the process gas from being deposited at corners of the gas storage member 310, thereby increasing utilization of the process gas.

As stated above, in the semiconductor heat treatment device provided in the embodiments of the present disclosure, joints and gaskets may be adopted to connect the first buffer section 311 to the gas intake section 110 and connect the second buffer section 313 to the communication section 120, so as to realize good sealing performance between those sections. In another embodiment of the present disclosure, a Vacuum Coupling Radius Seal joint 320 (i.e., a VCR joint) may be adopted for hermetic connection between the gas storage member 310 and the gas intake section 110 and/or between the gas storage member 310 and the communication section 120, and the VCR joint 320 may ensure good sealing performance between the gas storage member 310 and the gas intake section 110 and between the gas storage member 310 and the communication section 120, so as to prevent leakage of the process gas and improve process safety. Certainly, the VCR joint 320 may be adopted to connect any two components, such as the communication section 120 and the gas conveying pipeline 140 or the process chamber 210 and the exhaust pipeline 130, so as to ensure high connection reliability and good sealing performance between any two connected components in the semiconductor heat treatment device.

In addition, a joint connector 330 may be adopted to assist in connecting the gas storage member 310 to the VCR joint 320. Specifically, after the VCR joint 320 is inserted into the joint connector 330, an end of the gas storage member 310 is welded to the joint connector 330, thereby connecting the VCR joint 320 to the gas storage member 310 into a whole.

As stated above, the semiconductor heat treatment device may include the bearing mechanism for bearing the plurality of wafers 900 thereon. In order to further improve uniformity in deposition amount of the process gas on each wafer 900, optionally, the semiconductor heat treatment device provided in the embodiments of the present disclosure may further include a rotating mechanism 220, which may specifically be a rotating motor. The rotating mechanism 220 is installed at the process chamber 210, and the bearing mechanism is disposed in the process chamber 210 and installed on the rotating mechanism 220, so that the rotating mechanism 220 may drive the bearing mechanism to rotate, and a rotating direction is specifically a direction around the arrangement direction of the plurality of wafers 900.

For example, the plurality of wafers 900 may be arranged along the height direction of the process chamber 210, and the rotating mechanism 220 may drive the bearing mechanism to rotate along a direction around the height direction of the process chamber 210, that is, driving the bearing mechanism to rotate in a horizontal plane. Under the action of the rotating mechanism 220, the wafers 900 may rotate relative to the gas holes 141 on the gas conveying pipeline 140, which may ensure a uniform deposition amount of the process gas at any position of the wafers 900 and improve the process effect of the wafers 900.

In order to ensure that the process gas may be conveyed from the gas source into the gas storage member 310, the process gas needs to have a certain pressure while being conveyed, that is, the process gas in the gas conveying pipeline 140 also has a certain pressure. A gas can be easily liquefied when being pressurized, and some kinds of process gases have certain viscosity after being liquefied, which is not favorable to the conveying of the process gas. Accordingly, based on a fact that the pressure of the process gas in the gas storage member 310 is higher, the semiconductor heat treatment device provided in the embodiments of the present disclosure further includes a first heating mechanism and a second heating mechanism, the first heating mechanism is disposed at a heating pipeline for heating the gas intake section 110 to a first preset temperature, and the second heating mechanism is disposed at the gas storage member 310 for heating the gas storage member 310 to a second preset temperature. Under the effects of the first heating mechanism and the second heating mechanism, liquefaction difficulty of the process gas in the gas intake section 110 and the gas storage member 310 is increased, so as to avoid a phenomenon that the process gas is liquefied during the conveying process to the greatest extent, thereby increasing conveying efficiency of the process gas.

In addition, since the pressure of the process gas in the gas storage member 310 is higher than the pressure of the process gas in the gas intake section 110, the second preset temperature may be set to be higher than the first preset temperature, so as to ensure that the process gas in the gas storage member 310 is not liquefied. Specifically, each of the first heating mechanism and the second heating mechanism may be a heating device such as heating wires, and the first heating mechanism may wrap around the gas intake section 110 for heating the gas intake section 110. Correspondingly, the second heating mechanism may wrap around the gas storage member 310 for heating the gas storage member 310. Such arrangement of the first heating mechanism and the second heating mechanism has low difficulty. Specific values of the first preset temperature and the second preset temperature may be determined according to a kind of a process gas actually used in practical applications. Taking the process gas being SiH₂Cl₂ as an example, the first preset temperature may be 40°C, and the second preset temperature may be between 120°C and 150°C.

Based on the above semiconductor heat treatment device, an embodiment of the present disclosure further provides a control method for a semiconductor heat treatment device, so as to control the above semiconductor heat treatment device with the control method. As shown in FIG. 6, the control method includes:
S1, introducing a gas into a gas storage assembly through a gas intake pipeline.

That is, after a process is started, a portion of the gas intake pipeline (i.e., a gas intake section 110) which is located between a gas source and a gas storage member 310 is communicated, so that a process gas output by the gas source is temporarily stored in the gas storage member 310 of the gas storage assembly, and a pressure of the process gas may be generated in the gas storage member 310.

After step S1, the control method for the semiconductor heat treatment device provided in the embodiment of the present disclosure further includes:
S2, supplying the process gas to a process chamber 210 in a case where a gas storage amount of the gas storage assembly reaches a first preset value.

Specifically, the amount of the process gas required for performing a corresponding process on a plurality of wafers 900 may be obtained according to parameters such as the number and sizes of the wafers 900 in the process chamber 210 together with a specific type of the corresponding process. Then, in a case where the gas storage amount of the process gas in the gas storage member 310 reaches the first preset value, a first valve 410 is closed, and a second valve 420 is opened, so that the process gas stored in the gas storage member 310 may be quickly conveyed into a gas conveying pipeline 140 through a communication section 120 under the action of the pressure of the process gas itself, and may be conveyed into the process chamber 210 through a plurality of gas holes 141 in the gas conveying pipeline 140, thereby completing conveying of the process gas. In this way, it can be ensured that gas output amounts of the gas conveying pipeline 140 corresponding to the plurality of wafers 900 are substantially the same, thereby improving uniformity of a process result.

In addition, during the use of the semiconductor heat treatment device provided in the embodiments of the present disclosure, a specific value of the first preset value of the process gas in the gas storage member 310 may be tested. Specifically, a specific value may be first set for the first preset value of the process gas in the gas storage member 310, then the semiconductor heat treatment device is controlled with the control method provided in the embodiment of the present disclosure to perform gas conveying, a plurality of wafers 900 to be tested are subjected to a deposition process, and thicknesses and uniformity of deposition layers on all the wafers 900 are detected to obtain a corresponding relationship between the first preset value and the process result. Then, by changing the specific value of the first preset value and correspondingly completing the deposition process on the wafers 900, a plurality of sets of corresponding data may be obtained, and a corresponding relationship between the first preset value of the storage amount of the process gas in the gas storage member 310 and the specific parameters such as the sizes and the number of the wafers 900 may be obtained based on the plurality of sets of corresponding data. When the semiconductor heat treatment device is used subsequently, the specific value of the first preset value may be correspondingly determined according to the above corresponding relationship and parameters such as the number and sizes of wafers 900 to be processed, so as to ensure a good process effect of the wafers 900.

In some alternative embodiments, the control method further includes:
heating a gas intake section 110 to a first preset temperature; and
heating the gas storage assembly to a second preset temperature, with the second preset temperature being higher than the first preset temperature.

In order to ensure that the process gas may be conveyed from the gas source into the gas storage member 310, the process gas needs to have a certain pressure while being conveyed, that is, the process gas in the gas conveying pipeline 140 also has a certain pressure. A gas can be easily liquefied when being pressurized, and some kinds of process gases have certain viscosity after being liquefied, which is not favorable to the conveying of the process gas. Accordingly, based on a fact that the pressure of the process gas in the gas storage member 310 is higher, liquefaction difficulty of the process gas in the gas intake section 110 and the gas storage member 310 may be increased by heating the gas intake section 110 to the first preset temperature and heating the gas storage member 310 to the second preset temperature according to an embodiment of the present disclosure, so as to avoid a phenomenon that the process gas is liquefied during the conveying process to the greatest extent, thereby increasing conveying efficiency of the process gas.

In addition, since the pressure of the process gas in the gas storage member 310 is higher than the pressure of the process gas in the gas intake section 110, the second preset temperature may be set to be higher than the first preset temperature, so as to ensure that the process gas in the gas storage member 310 is not liquefied. Specific values of the first preset temperature and the second preset temperature may be determined according to a kind of a process gas actually used in practical applications. Taking the process gas being SiH₂Cl₂ as an example, the first preset temperature may be 40°C, and the second preset temperature may be between 120°C and 150°C.

The above embodiments of the present disclosure focus on the differences between the embodiments, and different optimization features of the embodiments can be combined to form better embodiments as long as the different optimization features are not contradictory, which will not be described in detail here for conciseness of the description.

The description above is merely of the embodiments of the present disclosure, but is not intended to limit the present disclosure. Various modifications and changes may be made to the present disclosure by those of ordinary skill in the art. Any modification, equivalent replacement and improvement made within the spirit and principle of the present disclosure should be included in the scope of the appended claims of the present disclosure.

## Claims

1. A semiconductor heat treatment device, comprising a process chamber, a gas intake pipeline, a gas conveying pipeline, and an exhaust pipeline, one end of the gas intake pipeline is communicated with a gas source, the other end of the gas intake pipeline is communicated with the gas conveying pipeline located in the process chamber, the gas conveying pipeline is parallel to a central axis of the process chamber, the gas conveying pipeline is provided with a plurality of gas holes, and each of the plurality of gas holes is configured to convey a process gas into the process chamber; and the exhaust pipeline is communicated with the process chamber, wherein a gas storage assembly is disposed on the gas intake pipeline, and is configured to supply the process gas to the process chamber through the gas intake pipeline and the gas conveying pipeline in sequence in a case where a gas storage amount reaches a first preset value.

2. The semiconductor heat treatment device of claim 1, wherein the plurality of gas holes are distributed along the central axis, and gas-conveying section areas of the plurality of gas holes gradually increase along a gas conveying direction of the gas conveying pipeline.

3. The semiconductor heat treatment device of claim 1, wherein the plurality of gas holes are distributed along the central axis, and a distance between any two adjacent gas holes among the plurality of gas holes gradually decreases along a gas conveying direction of the gas conveying pipeline.

4. The semiconductor heat treatment device of claim 1, wherein the gas storage assembly comprises a gas storage member, a first valve, and a second valve, the first valve is disposed on a portion of the gas intake pipeline which is located upstream of the gas storage member, and the second valve is disposed on a portion of the gas intake pipeline which is located downstream of the gas storage member;
the gas intake pipeline comprises a gas intake section and a communication section; the gas storage member comprises a first buffer section, a straight section, and a second buffer section, which are sequentially connected in series along a gas intake direction of the gas storage member, one end of the gas intake section is configured to be communicated with the gas source, the other end of the gas intake section is communicated with one end of the first buffer section away from the straight section, one end of the second buffer section away from the straight section is communicated with one end of the communication section, and the other end of the communication section is communicated with the gas conveying pipeline;
along the gas intake direction of the gas storage member, an area of a section of the first buffer section which is perpendicular to the gas intake direction gradually increases, and an area of a section of the second buffer section which is perpendicular to the gas intake direction gradually decreases; and
a shape of a projection of the straight section along the gas intake direction is the same as a shape of a section of the straight section which is perpendicular to the gas intake direction.

5. The semiconductor heat treatment device of claim 4, wherein the first buffer section is hermetically connected to the gas intake section through a Vacuum Coupling Radius Seal joint, and the second buffer section is hermetically connected to the communication section through a Vacuum Coupling Radius Seal joint.

6. The semiconductor heat treatment device of claim 1, further comprising a first heating mechanism and a second heating mechanism, wherein the gas intake pipeline comprises a gas intake section located upstream of the gas storage assembly and a communication section located downstream of the gas storage assembly, and the first heating mechanism is disposed on the gas intake section for heating the gas intake section; and the second heating mechanism is disposed on the gas storage assembly for heating the gas storage assembly.

7. The semiconductor heat treatment device of claim 1, further comprising a first pressure detection element, which is configured to detect a gas pressure in the gas storage assembly.

8. The semiconductor heat treatment device of claim 1, further comprising a mass flow controller, which is installed on the gas intake pipeline.

9. The semiconductor heat treatment device of claim 1, further comprising a bearing mechanism and a rotating mechanism, wherein the rotating mechanism is installed at the process chamber, the bearing mechanism is disposed in the process chamber, and is installed at the rotating mechanism, the rotating mechanism is configured to drive the bearing mechanism to rotate around the central axis, and the bearing mechanism is configured to bear a plurality of wafers.

10. A control method for a semiconductor heat treatment device, comprising:
introducing a gas into a gas storage assembly through a gas intake pipeline; and
supplying a process gas to a process chamber in a case where a gas storage amount of the gas storage assembly reaches a first preset value.

11. The control method for the semiconductor heat treatment device of claim 10, wherein the semiconductor heat treatment device further comprises a first heating mechanism and a second heating mechanism, the gas intake pipeline comprises a gas intake section located upstream of the gas storage assembly and a communication section located downstream of the gas storage assembly, and the first heating mechanism is disposed on the gas intake section for heating the gas intake section; and the second heating mechanism is disposed on the gas storage assembly for heating the gas storage assembly; and
the control method further comprises:
heating the gas intake section to a first preset temperature; and
heating the gas storage assembly to a second preset temperature; wherein the second preset temperature is higher than the first preset temperature.
